# EUROPEAN PATENT APPLICATION

(11) **EP 1 622 435 A1**
(43) Date of publication of application: **01.02.2006**
(21) Application number: 04090302.3
(22) Date of filing: 28.07.2004
(51) Int. Cl.: H05K 3/10, H05K 3/46, H05K 3/12, H05K 3/40, H05K 3/18, H05K 1/18

(54) **Method of manufacturing an electronic circuit assembly using direct write techniques**

(71) Applicant: ATOTECH Deutschland GmbH, 10553 Berlin (DE)
(72) Inventor: Baron, David Thomas, South Cerney GL7 5TG (GB); Hofmann, Hannes-Peter, 73525 Schwäbisch Gmünd (DE); Schneider, Reinhard, 12207 Berlin (DE)
(74) Representative: Effert, Bressel und Kollegen

(57) **Abstract**

To create very small lines and spaces (≤ 25 µm, preferably ≤ 10 µm and being as low as 5 µm) on electronic circuit assemblies with justifiable effort a method is utilized which comprises the following method steps: a) providing a dielectric layer (5); b) forming a three-dimensional structure (10,10',10'') in the dielectric layer so as to provide one or more structure elements in the layer selected from the group comprising via holes, trenches and component recesses; c) applying a fluid (12) to at least part of surface regions of the dielectric layer exposed in the structure elements, the fluid containing or forming at least one of conductive particles or intrinsic conducting polymer on the surface; and d) metallizing (13) at least part of the surface regions.

## Description

The invention relates to a method of manufacturing an electronic circuit assembly, more specifically a printed circuit board (PCB), a multi-chip module, a chip carrier or any other circuit carrier for electronic components, the assembly comprising one or more dielectric layers made from dielectric material, each layer having a conductor line structure.

Such manufacturing methods are well-known from prior art. In general the following method steps are accomplished to manufacture electronic circuits assemblies: i) providing a substrate, the substrate comprising one or more dielectric layers as well as a base copper layer on at least one side thereof, ii) generating a structure at the surface of the substrate which corresponds to the conductor line pattern to be formed, iii) depositing copper in those regions that correspond to the conductor line pattern to generate a conductor line structure, iv) removing the base copper layer adjacent to the conductor line structure. Alternatively the conductor line pattern may be formed after having generated the structure at the surface of the substrate in method step ii) by selectively etching the base copper layer.

DE 196 20 095 A1 discloses a method of manufacturing PCB, in which method recesses and via holes are generated in a dielectric layer by excimer laser irradiation preferably, the dielectric layer being clamped in a carrier frame. Thereafter the dielectric layer is provided with a base layer which is afterwards removed selectively except in those areas in which the recesses and via holes are located. Then the remaining base layer is metallized directly or after having been activated by light irradiation for creating a conductor structure, comprising for example conductor lines and plated via holes. Likewise alternatively selective treatment of the base layer may be dispensed of and instead deposition of metal thereon may be carried out, wherein the via holes may also be filled with metal. Thereafter the metal is completely removed by etching so that the dielectric surface is exposed and the recesses and via holes are filled with metal such that they are flush with the surface of the dielectric.

EP 0 677 985 A1 discloses a further method of manufacturing PCB. As may also be seen from DE 196 20 095 A1 recesses are formed in a carrier substrate by means of laser ablation, preferably with an excimer laser. Subsequently via holes are formed by means of laser ablation. After this an electrically conducting material is deposited substantially on the entire surface of the substrate. The conducting material is electroplated thereafter, the material being also deposited on the walls of the via holes. The holes are not completely filled with metal during this operation. Finally the electrically conductive material applied to the substrate is removed by means of a mechanical polishing method adjacent to the recesses and via holes. Selective deposition of electrically conductive material in the recesses and via holes may be effected by selective activation of the carrier substrate exclusively in the recesses and via holes by means of laser irradiation if a substance is applied to the walls of the recesses and via holes, which is rendered electrically conductive through laser irradiation.

The demands of present technology in the production of technical equipment, for example computers, handheld devices, mobile phones and digital cameras, are impacted by progressive miniaturization of circuit carriers. Circuit carriers need increasing circuitry density while the size of electronic components is diminishing. High-density PCB are required for these electronic components.

It is possible to create recesses and via holes in accordance with a circuit pattern in a dielectric material in fine resolution scale using such methods. However, creation of a higher circuit density is only possible to such an extent that plated via holes are not penetrating a too high number of circuit planes. To create a very high circuit density, compliance with certain conditions is essential, such as for example compliance with an aspect ratio of diameter and length of the via holes which shall be appropriate for metallization, as well as with a low area required for the via holes.

However, these techniques suffer from the drawback that production of highest-density circuit carriers with very small lines and spaces is only possible with extremely great effort to meet these requirements. In fact production of lines and spaces as low as 50 µm/50 µm with conventional photoresist technique and plating is only possible if considerable outlay is spent. This is in particular true if large panels with such small features are to be manufactured.

Apart from the wide-spread electroplating technology for the creation of conductor lines and metallized via holes further techniques for the formation of electrically conductive lines and walls in the via holes are available. Among these the thick film technique has become major importance long ago for certain applications. Thick film techniques use a screen print process to produce features down to about 100 µm wide. Alternatively thin film techniques have been developed long ago, too. These techniques employ masks and photoresists to produce sub-micron features. These techniques are costly and complex (Abstract to: M.J. Renn, B.H. King, M. Essien, "Maskless deposition technology targets passive embedded components" in: Proc. of the Techn. Progr. - Pan Pacific Microelectr. Symp., 7^{th}, Maui, HI, USA, Feb. 5-7, 2002 ; 296-300, publ.: Surface Mount Technology Association, Edina, Minn, USA).

Further techniques have been discussed but have not yet been commercialized and introduced to production facilities. All of these processes are capable of depositing a wide range of materials including: i) metal containing micro or nano particle inks; ii) dissolved or suspended polymers; iii) aqueous solutions containing a desired component; iv) molten solder or other low melting point alloys; and v) any material within a viscosity range suitable for each type of device. These techniques are all based on the so-called "Direct Write Digital Deposition" technology (DWDD). These processes comprise industrial ink-jet technique, micro-pen or micro-syringe technique, laser aerosol technique, transfer printing, mill-and-fill technique and gas dynamic spraying technique.

The potential of all these techniques is
a) The material is only put to those areas on the assembly substrate where it is needed. This enables fundamental environmental as well as cost benefits.
b) The number of process steps required to produce a PCB is significantly reduced. The techniques are capable of producing a completed electronic circuit.
c) >Multiple materials can be deposited utilizing a combination of the new and old deposition methods.
d) Significant reduction in production space is achieved compared to traditional methods.

All of these techniques are based on three parts which are needed to carry out any of these techniques: i) a supply of material to be deposited; ii) a deposition head and associated software and controls, which are needed to supply the material to the assembly substrate; and iii) a XYZ substrate table/bed system, motion controls, direct video feedback and software. Such instrumentation is commonplace in the industry for laser drilling, surface mount technology etc.

Each of the deposition techniques has its own strengths and weaknesses. These may be summarized as follows:
Industrial Ink-Jet Technique:
   - Good positional accuracy (± 1 µm); fast scan rates;
   - Image edge definition/resolution is limited by the droplet size (75 - 100 µm lines and spaces); off-contact is an issue: since the distance between the inkjet head and the substrate is very small (below 1 mm), maximum resolution is only achieved when the substrate is adjusted accurately;
   - Good at filling a three-dimensional structure (holes and trenches);
   - The deposited layer thickness can be lower than required; then multi-pass is needed;
   - The electrical conductivity of the deposited material often is too low when the material is not cured after deposition; for example, a volatile organic layer containing the conductive material, which after deposition is evaporated by baking or a laser technique, can be applied to achieve sufficient conductivity;
   - Low viscosity materials are required for the most part;
   - After the ink has been deposited discrete electroplating may be required to provide correct electrical conductivity and dimensions.
Micro-Pen/Micro-Syringe Technique:
   - Good positional accuracy (± 1 µm); slow scan rates;
   - Image edge definition/resolution is excellent;
   - Surface deposition of the material and deposited layer thickness are acceptable for most cases;
   - The electrical conductivity of the deposited material can be an issue if the material is not cured after deposition;
   - A wide viscosity range is possible;
   - After the material has been deposited discrete electroplating may be required to provide correct electrical conductivity and dimensions;
   - With this technique material may be mixed a few milliseconds before deposition.
Laser Aerosol Technique:
   - Good positional accuracy (± 1 µm); medium scan rates;
   - Image edge definition/resolution is excellent, the feature size is limited only by the beam coherence;
   - Surface deposition of the material and filling of the three-dimensional structure in the substrate are acceptable;
   - The deposited layer thickness can be lower than required; then multi-pass is needed;
   - The electrical conductivity of the deposited material is acceptable because the material is cured by means of the laser beam;
   - A wide viscosity range is possible; however aerosol formation can only occur from low viscosity solutions;
   - After the material has been deposited discrete electroplating may be required to provide correct electrical conductivity and dimensions;
   - With this technique material may be mixed a few milliseconds before deposition.

The tools to be used in industrial ink-jet technique have been developed by MicroFab Technologies (Texas, US) for example. The system comprises a print-head positioned above the substrate. The substrate is held by a substrate holder which is again held by an X-/Y-stage with appropriate motion control. Further there is a Z-stage with appropriate motion control to move the print-head in Z-direction. Vision systems are provided for controlling direct write performance.

Application of industrial ink-jet technique is for example described in WO 03/049515 A1. This document discloses a printer comprising a print-head adapted to eject at least two separate fluids towards a substrate, the print-heads being connected to respective reservoirs to apply fluid thereto, and the fluids being able to react chemically when in contact to yield a product having conductive properties differing from those of the fluids. The fluids may be solutions containing PdCl₂ and SnCl₂ for example. Reaction of these species results in formation of an activator of catalytic palladium metal such that electroless plating of metals, such as Co, Ni and Cu in the manufacture of PCB, could be promoted. This document is silent as to the possibility of producing extremely small structures and the possibility of doing so.

The tools to be used in micro-pen or micro-syringe technique are available from nScrypt (Oklahoma, US) and OhmCraft (New York, US) for example. They have developed a system for depositing fine lines composed of a variety of materials. The system has been optimized with respect to the syringe dispension system, the software for the computer control, the to be deposited material and substrate interactions and post-processing requirements. Furthermore laser processing for annealing has been considered. It has turned out that the angle at the nozzle orifice tip is preferably small to achieve optimum minimum pressure drop along the axis of and inside the tip with nearly uniform velocity distribution at the tip orifice, resulting in improved conditions for the start/stop mode.

The tools to be used in laser aerosol technique are available from Optomec (New Mexico, US). Optomex has developed a method and tools to perform this method for additive manufacturing. Using a Nd:YAG laser and an aerosol gas feed to deposit material to a substrate extremely fine lines and other structures were manufactured. Materials to be deposited are metals, resistance materials, ferrites and dielectrics. Due to irradiating the laser beam to the location where aerosol is hitting the substrate surface the material is fixed.

A 2 - 3 µm silver particles containing liquid to be used in the mill-and-fill method has been developed by Parelec (USA).

Ink-jet technique has already been applied to deposit legend/notation to PCB and the production of flat panel displays using Poly OLED (Organic Light Emitting Devices) technology.

An example for the laser aerosol technique is described in M.J. Renn et al., *ibid.:* Without the use of masks or photoresist deposits electronic materials are deposited onto low-temperature, planar and non-planar substrates. 25 µm lines of inorganic and organic materials may be deposited onto polymer, glass, silicon, alumina and other ceramic substrates. In the process aerosolized particles as small as 20 nm in diameter are deposited using aerodynamic focusing. Approximately one billion particles per second can be deposited with a definition on the order of 25 µm. After the deposition process is completed, the material is decomposed or densified to produce the desired electrical and mechanical properties. The process uses thermal or laser processing to obtain the desired properties by virtue of the initial precursor chemical or localized laser heating. Specifically the process can deposit electronic materials onto low-cost polymer substrates that cannot withstand high-temperature oven fires. The tool used will allow manufacturers to integrate many active and passive components into one compact, lightweight and conformal electronic system. Resistors, capacitors and inductors can be embedded into the board.

Another method of applying electrically conducting material to a substrate by laser aerosol deposition is described in WO 97/11589 A1. In this case doped tin oxide is deposited on glass or ceramics for patterning conducting tracks on a surface for the manufacture of PCB. Deposition takes place at 400 - 600°C by aerosol spray pyrolysis.

Japan Patent Abstracts to JP 2003-318542 A discloses a method of forming a multilayer wiring board. For this purpose a silver line is formed on a polyimide film by a droplet discharging method.

Further WO 01/82315 A1 discloses an ink composition which comprises a reactive organic medium and a particulate metal oxide or mixture of oxides. The composition can be consolidated to a monolithic pure metal oxide. Such ink may be used to produce passive electronic components, such as for example resistors. The ink is applied to the substrate by printing.

The direct write techniques suffer from low electrical conductivity of the conductor material formed and - more essential - from the fact that electrical conductivity of these layers may not be easily defined in the manufacturing process. Electronic industry, however, requires well-defined (constant) electrical properties of the conductor lines and connector vias between individual circuit planes. Another drawback of the techniques as described is that thickness as required often may not be easily achieved by single pass deposition of the material applied. Therefore multiple pass is mandatory. This, however, requires additional time, labour and investment and eventually poses the problem of reduced accuracy of the line definition. The new techniques further have the disadvantage of their inability to meet the highest technology requirements at a competitive price.

Therefore a major object of the present invention is to provide a method of manufacturing an electronic circuit assembly, while avoiding the drawbacks of prior art. It will be of specific importance to find out a method of manufacturing an electronic circuit assembly which has very small lines and spaces (≤ 25 µm, preferably ≤ 10 µm and being as low as 5 µm) and which may be manufactured with justifiable effort, while achieving the requirements specific to circuit boards in the art, i.e. improved impedance because all lines are buried and not exposed to air as today.

This object is achieved by the method according to claim 1. Preferred embodiments of the present invention are described in the sub-claims.

Before the present invention of manufacturing an electronic circuit assembly is disclosed and described, it is to be understood that this invention is not limited to the particular process steps and materials disclosed herein as such process steps and materials may vary somewhat. It must be noted that, as used in this specification and the appended claims, the singular forms "a", "an" and "the" include plural referents unless the content clearly dictates otherwise.

The term "electronic circuit assembly" as used herein refers to a device that is designed so as to comprise conductor lines comprising lands, via holes, including blind holes and buried holes, as well as other electrically conducting elements and which, when combined with appropriate electronic components being mounted to this device, fulfils any specific electronic function, such as in a personal computer or handheld device main processor or controller, in a main processor or a controller for a digital camera, simply as a keypad circuit board for a mobile phone or as any other circuit assembly for an electronic device. Therefore this device comprises one or more dielectric layers and one or a plurality of conductor lines and other conducting structure elements on these layers which serve to electrically connect the individual electrical components together. The device may comprise a plurality of circuit planes of such dielectric layers with conductor lines, lands and other circuit structure elements and for this purpose also comprises a plurality of connector vias between the individual planes. The device may further comprise carrier structure elements such as a metal/metal oxide or metal/dielectric polymer core which carries on the outer sides thereof such circuit planes. The assembly may further be equipped with active and/or passive electronic components, such as resistors, capacitors, inductors, antennas (for RFID tags for example), RC filters, transformers, transducers, piezomagnetic, piezoelectric and chemical or mechanical sensors (passive components) and semiconductor devices, such as integrated circuits and other devices like transistors and diodes (active components). Such components may be discrete components that are mounted to the circuit planes by gluing, soldering, bonding or any other conventional technique. Alternatively, the passive electronic components may be manufactured on the dielectric layers by printing, spraying, writing or other processes. The components may be embedded in the circuit planes. This allows more surface area for main processors in handheld devices for example and to further reduce cost. The assembly may have, but is not limited to, a planar structure with the circuit planes and, where applicable, carrier structure elements either having a planar structure.

The term "conductor line" as used herein refers to any electrically conducting element that electrically connects lands for an electronic component among each other or via holes and lands for an electronic component or via holes among each other or other items in a circuit plane. The conductor lines are preferably made from copper or from a combination of copper and any further electrically conducting material. The line definition of the conductor lines is preferably optimized to the extent that the surface and edges thereof are as smooth as possible and the line width and thickness is as uniform as possible.

The term "land" as used herein refers to any electrically conducting element that serves to electrically connect an electronic component to the conductor lines. The electronic components may be electrically connected to the lands by bonding, soldering and other conventional techniques.

The term "dielectric material" as used herein refers to any material that is not electrically conducting. The material may be either organic or inorganic. If it is organic it may preferably be a polymer, such as for example polyimide, fluorinated polymer (e.g.

PTFE), epoxy resin (e.g. FR4 [flame retardant epoxy/glass fiber laminate], high-T_{g} FR4 material, BT resin, cyanate ester resin), APPE, EPPO, LCP (liquid crystal polymers, phenolic resin, acrylic resin, polyalkylene resin, polyurethane resin and other conventional polymer, as well as a composite material composed of the aforementioned resins and further, preferably reinforcing, material such as glass (laser glass from Isola or Dielektra or Thermount® from DuPont) or quartz fibers, carbon fibers, ceramic fibers, polymer fibers, glass powder, quartz powder, ceramic powder and paper. The reinforcing material is used for enhancing the dimensional stability of the material. Using flatly woven glass having a UV absorbing coating (Isola, Dielektra) enables even laser ablation of the material. The dielectric may further be ceramics.

The term "three-dimensional structure" as used herein refers to any depression in the dielectric layer. The three-dimensional structure comprises structure elements, such as trenches, via holes and other recesses which may be for example component recesses. The structure elements correspond to the circuit pattern. The trenches and via holes may by superimposed in that a via hole is for example located within a trench.

The term "trench" as used herein refers to a recess which defines a conductor line in that the depth, length and width of a specific trench preferably have the same dimensions as the conductor to be formed in this trench by substantially filling such trench. The same holds true for lands which are likewise formed in trenches so appropriately shaped. The cross-section of the trenches and lands is preferably rectangular or has a groove (V)-shape, but may of course have any suitable shape.

The term "component recess" as used herein refers to a recess which serves to accommodate electronic components and for this purpose approximately has the same shape as the components. The components recesses preferably have a depth that is greater than the height of the electronic component to be able to embed the component in the dielectric layer. Electrically conducting structure elements may be formed in the component recesses to electrically connect the terminals on the electronic components to be inserted in such recesses to other conductor structures in the circuit plane. The cross-section and plan view of the component recesses is preferably rectangular but may of course be of any shape as required.

The term "via hole" as used herein refers to an aperture in the dielectric material which touches at least two circuit planes so that electrical connection may be made between these planes via such via hole. In most cases via holes only connect two such planes. If such a via hole is located at the outer side of the assembly it will be a blind hole. If it is located between two layers which are situated beneath the outermost circuit plane it will be a buried hole. Via holes are preferably cylindrical.

In addition the structure elements may also correspond to other functional devices to be manufactured, such as for example shielding means (metallized areas to shield against electromagnetic emission and/or immission).

The term "particles" may comprise conductive particles and electrically isolating particles. The latter may be for example dielectric particles, such as SiO₂, Al₂O₃, SrTiO₃, polyurethane, polyacetate and various glass particles.

The term "conductive particles" as used herein refers to any particles that are conductive particles, which have a metallic or semiconducting conductivity. The particles may for example be metal particles, for example Cu, Ag, Au, Pd, Pt, Ni, Co, Sn, Zn, Bi, Al, In, alloys of these metals with each other and with other elements, semiconductors, such as for example metal oxides (e.g. ITO [indium-tin oxide]), metal sulfides, metal tungstates and other semiconductors, resistance material particles, such as Ni/P, AgPt, RuO₂, SrRuO₃ and electrically conductive carbon such as graphite, (colloid graphite particles for example), electrically conducting polymers, such as for example polypyrrole and polythiophene and dielectric particles. The conductive particles are preferably nanoparticles and may be spherical. They may also be carbon nanotubes. The particles may also be composed of a combination of the materials mentioned and of further materials, such as for example coated particles, such as for example particles having an isolating core of glass or ceramics or of a polymer coated with a metal layer. Manufacture of the particles is well-known. For example particles having a polymer core and a metal coating may be formed from micro polymer particles which are plated with metal using a conventional plating technique. The particles are dispersed in a fluid, such as for example in an aqueous medium, optionally containing surface active agents and/or organic solvents. The particles may also be formed upon a reaction between two media in which suitable substances are contained, such as for example a heterocyclic monomer reacting with an acid and an oxidizing agent to form an intrinsic conductive polymer.

The term "intrinsic conductive polymer" as used herein refers to any polymer material which is electrically conductive due to its polymer structure, such as polyacetylene, polythiophene, polypyrrole, polyaniline and the like. Such polymers may for example be formed by oxidizing the respective monomers in the presence of suitable anions (acids), thereby forming electrically conductive polymeric salts, such as polypyrrolium p-toluene sulfonate.

The term "direct write technique" as used herein refers to any technique which is capable of producing a pattern on the surface of the circuit assembly using a mask-less method in which the pattern is generated by sequential "writing" with a suitable means. For this purpose the writing means, such as the print-head in the ink-jet technique, or the substrate to be treated or both are moved relative to one another, in order to produce the pattern on the substrate. For this purpose an X-/Y- and optionally a Z-motion control and a substrate holder as well as further suitable viewing control means are provided. Such movement may be a line-by-line relative movement or a movement along the conductor lines or other structure elements of the pattern. In general it will be necessary to directly create the pattern discontinuously, *i.e*., by starting writing, then writing and, after having terminated a certain portion of the structure to be written, again breaking the writing-motion off (start/stop mode). Such methods are for example the ink-jet (printing) technique, the micro-syringe or micro-pen (alternatively Quill-pen) technique, any transfer printing technique, laser aerosol technique or mill-and-fill methods. Furthermore a gas dynamic spraying technique optionally followed by laser ablation will also be considered a direct write technique. Differentiation between these methods has been made herein before with respect to the principle of the method of generation of the pattern. With respect to the material that is used to produce the patterned layer differentiation may also be made between so-called conductive particles application techniques and all other direct write techniques. The former conductive particles application techniques comprise all methods in which a material is deposited to form a layer which contains electrically conductive particles, such as layers composed of metal particles dispersed in a binder. Apart from this embodiment patterned layers are produced with other direct write techniques which do not contain electrically conductive particles, such as for example layers containing intrinsic conductive polymers, dielectric material including optically transparent material for lenses and waveguides, ceramics and biologic material. The material deposited with the direct write technique will be selected to have the desired properties with respect to rheology (non-Newtonian for example), viscosity, tensile strength, surface tension (contact angle to the substrate material), electrical conductivity or catalytic activity with respect to further metallization. The material deposed with the direct write technique may advantageously be sintered (cured, annealed) after the deposition method in order to provide same with the desired properties. This sintering may also be suitable to enhance adherence of the produced layer to the substrate surface. It may be effected by heat or laser treatment, for example.

The method according to the invention serves to manufacture an electronic circuit assembly. The assembly comprises one or more dielectric layers made from dielectric material, each layer having a conductor line structure, the method comprising the following method steps:
a) providing a dielectric layer;
b) forming a three-dimensional structure in the dielectric layer so as to provide one or more structure elements in the layer selected from the group comprising via holes, trenches and component recesses;
c) applying a fluid to at least part of surface regions of the dielectric layer exposed in the structure elements, the fluid containing or forming at least one of conductive particles or intrinsic conducting polymer on the surface, wherein the fluid more preferably contains conductive particles suspended therein or is capable of forming conductive particles at said surface regions; and
d) metallizing the surface regions in the structure elements.

The method according to the present invention has many advantages over prior art methods, because it eliminates:
i) The use of copper foil/prepreg (FR4 resin layers reinforced with glass fiber mats, B-stage) or resin coated copper laminate;
ii) Photoimaging and the work associated with photo-tool production, the protection and use thereof;
iii) Subtractive circuit definition processes such as develop, etch and strip methods; this avoids waste management problems;
iv) Larger volumes of toxic waste.

The method of the invention has the main advantage of offering the possibility of manufacturing extremely fine conductor structure elements. This enables easy electrical connection of semiconductor devices which have a very fine pitch at the terminal side of the components to the terminal side of the assembly. It is for example possible to directly attach semiconductor devices to the assembly which have a ball grid array or fine grid array without the need to use chip carriers or any other intermediate devices. The conductor structure elements may have the following dimensions: width of conductor lines: <10 - 80 µm, height of conductor lines: < 10 - 50 µm, diameter of via holes: < 10 - 80 µm, length of via holes: 50 - 130 µm (maximum height of the via holes corresponds to the thickness of the dielectric layer; the dielectric layer typically has a thickness of 50 - 130 µm).

Further manufacturing a circuit pattern using the method of the invention enables the use of blind holes which are metal-filled to electrically connect two circuit planes. This has additional benefits over a conventional design having through-holes penetrating the whole assembly: Depending on the overall depth of the assembly through-holes must be designed to have a minimum diameter since achievement of plating is no longer possible in holes having a too low aspect ratio (ratio of diameter over length; minimum diameter therefore 150 µm). In addition through-holes normally possess residual conductor rings at the entrance thereof which is needed for the design of the conductor pattern. The space required by the holes is thus even more increased. Correspondingly large areas of the circuit plane cannot be used for the circuit pattern.

After a first circuit plane has been manufactured by formation of a conductor structure comprising for example conductor lines and metal-filled via holes, further circuit planes may be formed by applying a further dielectric layer to the assembly which may be provided with a second and further circuit pattern according to the method steps a) through d).

Furthermore the novel method has the benefit of being much shorter than prior art methods. Therefore it does neither suffer from the shortcomings of minor process reliability. This also assures a simplified process sequence and reduced material usage. This is associated with the fact that less registrations steps are needed and therefore production bottlenecks are prevented. Likewise this leads to higher first pass yields, because the deviation in registration which occurs at each individual registration step, due to deviations occurring at each position recognition and alignment, is smaller because of the reduced number of process steps. This is especially significant if a greater number of circuit planes have to be manufactured. Assemblies with two circuit planes can be produced by singly accomplishing the method steps a) through d) at each side of the dielectric layer by simply positioning the layer once and filling the structure elements with metal or another appropriate conducting substance.

Another very important advantage of the method according to the present invention over prior art methods is that it may furthermore be employed with any dielectric material and is thus very versatile. Moreover this also enables adhesion without the need to have high dielectric surface roughness, thereby providing improved impedance control and signal attenuation capability.

Moreover landless via production is possible without the need to tighten imaging operating windows. The method also enables lines and spaces with a width of below 10 µm with high yield. This circumstance and further the possibility to encapsulate electronic components into the dielectric layer makes it possible to significantly enhance conductor packaging density allowing PCB technology to bridge the widening gap between itself and the integrated circuit industry requirements.

As the dielectric layer may be three-dimensionally structured, easier mechanical reinforcement is possible for solder balls by forming appropriate recesses. As the electronic components may be embedded into the dielectric layer greater reliability is imparted to the assembly because many components are encapsulated as part of the production process.

The dielectric material may be bonded to a carrier. The carrier serves to impart mechanical stability to the assembly at least during the manufacturing steps. Furthermore it may be used to supply electric current to the assembly during the electroplating step, if the structure elements are electrically connected to the carrier and if the carrier itself is electrically conductive. For this purpose electrical contacting points are provided in the circuit planes as a current supply which are located outside the area in which the three-dimensional structure is formed and which are brought into an electrical contact with the carrier. The dielectric is applied to the carrier in such a way that roughness at the phase boundary between the dielectric layer and the carrier is as low as possible. Same holds also true for the subsequent application of further dielectric layers to generate additional circuit planes. This is in contradiction to conventional methods in which dielectric is bonded to copper via an interphase with relatively high roughness. Due to this smooth interphase, impedance control is much easier accomplished than with previous methods and undesirable capacitances are avoided. Therefore impedance controlled circuits may be achieved with this method easily.

The carrier may be selected from the group comprising a multilayer core material, a metal plate, such as for example a stainless steel press plate, a dielectric film, such as for example a release film, and a semiconductor device. The carrier is preferably formed as a sandwich.

If the carrier is a multilayer core material then the dielectric material is preferably attached to the carrier on both sides. The multilayer core material may be any conventional multilayer material well-known to those skilled in the art, *i*.*e*. a multilayered circuit carrier being composed of a plurality of dielectric layers, which preferably consist of FR4 material and a copper conductor structure to particularly connect plated via holes in the inner layers and via holes and/or lands on the outer sides. The multilayer core material may also be any of polyimide, fluorinated polymer (e.g. PTFE), epoxy resin (e.g. FR4, high-T_{g} FR4 material, BT resin, cyanate ester resin), APPE, EPPO, LCP (liquid crystal polymer), phenolic resin, acrylic resin, polyalkylene resin, polyurethane resin and other conventional polymer, as well as a composite material composed of the aforementioned resins and further preferably reinforcing material such as glass (laser glass from Isola or Dielektra or Thermount® from DuPont) or quartz fibers, carbon fibers, ceramic fibers, polymer fibers, glass powder, quartz powder, ceramic powder and paper.

For manufacturing the multilayer core carrier the following combinations of single-sided copper-coated material with prepregs may be chosen: Laserpreg, Tg: 170°C + Laserpreg, T_{g}: 170°C; IS620, T_{g}: 200°C + IS620, Tg: 200°C, N4000-13, Tg: > 210°C + N4000-13, T_{g}:210°C, N4000-6 LD + N4000-6LD, Tg: 175°C, Tg: 175°C, N5000 BT, T_{g}: 185°C + N5000 BT, Tg: 185°C, AKAFLEX KCL PI + AKAFLEX KCL Pl.

The metal layer is preferably a copper layer or a steel layer, more preferably a stainless steel press plate. Nickel and copper can be electroplated to the steel layer. Preferably one side or both sides of this plate may be coated with a complete coating of nonporous copper with a film thickness of < 2 µm. The metal layer may be structured using a conventional print-and-etch method or a semi-additive method. This layer is preferentially a rigid conductive carrier layer. Alternatively the carrier may also be a release film which is preferably a smooth but rigid, non-stick carrier layer. Such release film may for example consist of fluoroplastics, like PTFE (poly tetrafluoro ethylene), FEP (fluoro ethylene propylene), PFA (perfluor alkoxy), ETFE (ethylene tetrafluoro ethylene copolymer), E-CTFE (ethylene-chloro trifluoro ethylene), PVDF (poly vinylidene fluoride) or PVF (poly vinyl fluoride). Alternatively the carrier may also be a frame, which serves to clamp the assembly taut.

The carrier may be removed from the dielectric layer after method step c) or d). In this case the dielectric layer with conductor structure elements formed in the three-dimensional structure is further used without such carrier. Under such conditions further conductor structure elements may be formed on the side of the dielectric layer which has until then been attached to the carrier to form double sided applications (bidirectional formation of circuit planes, especially advantageous after one circuit plane has been manufactured). If the carrier is not removed from the dielectric layer the carrier imparts stability to the circuit assembly and also creates further interconnections if a multilayer core is used as the carrier. Easy removal of a steel plate is possible if the plate is nickel-plated.

The carrier may be used as a base for the blind holes of the lowermost circuit plane. For this purpose the carrier serves as a "land" while via holes are produced by laser drilling in the dielectric layer, so that further penetration of the laser beam into the material is prevented. If the carrier is a metal layer, a multilayer core or other PCB or a semiconductor device, such as a chip, electrical contact for electroplating may be achieved through these via holes. If a PCB is employed as a carrier via holes are preferentially created at those places where metal areas are located on the outer side of the PCB. If the carrier is removed at a later stage of the process the exposed contact areas at one end of via holes filled with conductive material may then be employed as lands for electronic components, such as for example ball grid arrays. Consequently while forming a circuit plane on the uppermost dielectric layer a further circuit plane is formed at the lower side of the released assembly. If possible the dielectric material may be structured and a circuit pattern be generated at the lower side thereof after the carrier has been removed using the method of the invention.

The three-dimensional structure is preferably generated by laser ablation of the dielectric material. It may, however, also be generated by hot embossing, moulding, micro stamping, micro imprinting or other technique depending on dielectric type. In this step trenches, via holes and any other recesses, like component recesses, can be formed. The recesses formed by laser ablation are preferably V-shaped, such as grooves. This further facilitates electroplating in the trenches and via holes, since the depth of the grooves is small compared to the upper aperture thereof.

For laser ablation focussed or non-focussed laser light is used. In the latter case (projection method) a metal mask is used to produce the ablation structure. The non-focussed laser beam is directed through finest apertures forming the circuit pattern in the mask. In the former case (direct focussing method) the focussed laser beam is scanned over the surface of the dielectric layer, so that the structure elements are formed by "writing".

The preferably used laser emits laser light in the UV or blue visible wavelength region. Well-suited lasers emit light with a wavelength of 192 nm, 248 nm, 308 nm or 355 nm. Preferably suited lasers are argon ion lasers and excimer lasers. FR4 material may be preferentially treated in the projection method using excimer laser having a light wavelength of 308 nm.

The dielectric layer is preferably ablated using a pulsed laser. This method is preferred because the amount of ablated material may be reproducibly adjusted, since each single laser pulse comprises a defined energy amount. To achieve a defined ablation depth the dielectric layer is irradiated with a previously established number of laser pulses. By systematic irradiation with a defined laser energy amount in each individual pulse sparing ablation of the material is possible. Starting from a high value the energy amount may for example by reduced gradually so that the non-ablated material will not be damaged at the walls and at the bottom of the recess. This not only enables etching the material down to a defined depth if the via hole touches a metal base layer but also if the via hole ends as a blind hole in the dielectric material.

Laser ablation may for example be carried out by scanning the beam crosswise across the dielectric layer. For this purpose a first bundle of recesses which are preferably parallel to one another is formed in the layer by means of the projection method or by means of the laser direct focussing method. Thereafter a second bundle of recesses is formed which are also preferably aligned in parallel to one another and which cut the recesses of the first bundle and are preferably aligned to the first ones at a degree of about 90°. Using the projection method and employing a line mask the recesses of the first bundle may be created in a first method step for example. Then the second bundle of recesses is formed in a second laser step after turning the dielectric layer or the line mask by an angle of about 90° for example. At those areas at which the recesses cross each other, blind holes are formed since at these locations more material is ablated due to the repeated laser treatment than at those locations in which no crossings are created. The blind holes may have a depth corresponding to the thickness of the dielectric layer, depending on the energy amount irradiated and on the type of dielectric material.

If the method using direct focussing of the laser as described herein before is carried out, any circuitry having via holes may be manufactured: For this purpose the laser is scanned over the surface of the dielectric layer in those scan lines parallel to one another in which recesses shall be formed. However, the laser beam is directed to the layer only then when a conductor line section is to be generated at the respective location, while the beam is shut down when no such section is to be formed at the respective location.

For carrying out the alternative method of embossing to form the structure elements, plates (masters) are employed, which have a relief with the circuit pattern on the surface thereof, and are pressed into the dielectric material to generate the desired recesses and via holes.

The conductive particles which are suspended in the fluid or formed from a fluid, for example a solution, in step c) may be used to prime all or only a few of the structure elements or only part of each structure element to generate a conductor structure therein (such as electrically connecting structure elements in component recesses) or the whole dielectric layer or only part thereof prior to further metallizing according to method step d).

The conductive or catalytic layer comprising at least one of conductive particles or intrinsic conducting polymer on the surface may be deposited by one or more direct write techniques which are selected from the group comprising ink-jet technique, micro-syringe or micro-pen technique, laser aerosol technique, mill-and-fill technique and gas dynamic spraying technique.

The direct write techniques may for example be conductive particles application techniques. If they are conductive particles application techniques, they are characterized by making a conductive layer comprising conductive particles. This layer may be used as a prime layer to further plate metal thereupon. The prime layer serves to pre-treat the dielectric material for further plating of metal thereupon. This prime layer may eventually completely or at least partly substitute noble metal catalyst pre-treatment and any other pre-treatment normally necessary to plate metal on dielectric material. It may eventually, however, be necessary to additionally catalyze the prime layer (e.g. by depositing noble metal from an aqueous noble metal ion solution by charge exchange reaction). The prime layer may also mediate adhesion of the plated layer to the dielectric material by creating a specific bond between the prime layer and the dielectric if a suitable binder or bonding agent is used in the conductive particles layer (e.g. a suitable organic polymer if the dielectric is organic or a suitable inorganic material if the dielectric is inorganic). Adhesion enhancers may be used to further enhance adhesion of the conductive particles layer to the dielectric. Such enhancers may for example comprise quarternary ammonium salts or catalytic ink.

The ink-jet technique is characterized by producing the desired pattern in the surface regions of the dielectric layer exposed in the structure elements by directly writing. This is done by precisely placing very small droplets of a suitable fluid in the respective regions. For this purpose computer-controlled print-heads are used which eject the fluid out of very tiny orifices in the print-head and toward these regions. Such print-heads are well-known from ordinary ink-jet technology for printing on paper or other material. The fluid may be ejected from the print-head by means of a piezoelectric or a piezomagnetic or a piezoelastic effect. For this purpose in general a reservoir for the fluid is provided in the print-head and a mechanical pulse is exerted to the fluid such that a small droplet is ejected from the reservoir. The velocity of this droplet is very high such that intimate contact thereof with the assembly surface is ensured once it has hit the surface. For the writing process the print-head is moved relative to the surface of the dielectric layer at a small distance to it. During this relative motion continuous or discontinuous ejection of the fluid toward the assembly takes place. Either the print-head or the assembly or both may be moved in an X- or Y-direction line-by-line or just along the pattern structure to be written. The fluid is designed to produce the layer which shall have the desired properties. For example the fluid is a dispersion containing silver particles. The fluid may contain the particles or any other material to be deposited and a suitable solvent. The solvent is preferably selected such that it evaporates after deposition.

The micro-pen or micro-syringe technique is characterized by writing the material to be deposited to the assembly surfaces by drawing a pen- or syringe-like tool across the surface and in contact with it and by depositing the material by pressing same out of the pen or syringe with a piston for example. During this motion the material is ejected through an orifice at the tip of the pen or syringe and deposited on the surface. For this purpose the pen or syringe has a fluid-filled nozzle. Depending on the structure to be generated with this technique the orifice at the tip of the nozzle has an opening diameter of preferably 50 µm to 2 mm. The material to be ejected may be pressed out of the pen or syringe by exerting a suitable pressure on the material being contained in the reservoir. The particles are preferably nanoparticles. The solvent is preferably a low-boiling liquid, such that it will be evaporated easily after contact with the surface or the dielectric layer. For this purpose the fluid may be heated at low temperature after deposition to evaporate any solvent therein and then be annealed to sinter the particles together which are left behind on the surface. The material may also be a solder paste and adhesive, sealant or die attach. The pen or syringe is moved across the assembly surface with the aid of computer control.

Further a transfer film technique (for example MAPLE DW = Matrix Assisted Pulsed-Laser-Evaporation Direct Write) may be used. In his method the material to be deposited is first deposited to a transfer backing (the so-called "ribbon"), such as for example to a transparent polymer film, being preferably 1 -10 µm thick. This film is placed at the surface of the assembly such that material to be deposited is positioned directly opposite the surface regions to be coated. A pulsed laser beam, a 355 nm UV laser for example, is then directed to the transfer film at those areas in which material shall be deposited on the assembly surface. The binder in the material on the film will be evaporated upon irradiation such that the vapour fires the remaining solids in the material at great speed toward the assembly surface to come into intimate contact therewith. For executing the method the transfer film is driven forward to the desired position in front of the assembly surface. Then the laser pulse is generated and the solid is deposited. By moving the assembly and the film or the laser beam and the film, the material is deposited to the desired positions. For this purpose again an X-/Y- and optionally a Z-motion computer control and an assembly holder as well as further suitable viewing control means are provided. After deposition the material is preferably sintered to achieve the desired property of the directly written structure elements. For this purpose a laser may advantageously be used. For this purpose an infrared laser is preferably used. Alternatively the electronic assembly may be heated in an oven. The laser may also be utilized to form blind or through vias by laser ablation. Further excess material may also be ablated with the aid of the laser.

Further a laser aerosol technique may be used. For executing this method a laser and an aerosol generating means are used. The aerosol is produced from a fluid suitable to form an electrically conductive or catalytic layer on the surface of the substrate. The aerosol may be generated by any conventional technique in an atomizer, such as by conventional pneumatic or ultrasonic generation, producing small aerosol droplets (1 - 5 µm diameter) in a carrier gas stream, *e.g.,* an argon gas stream. The fluid to produce the aerosol and hence the aerosol contain the material to be deposited. With this method metals, such as for example Au, Pt, Pd, Ru, Cu, Ag and Ni as well as alloys thereof, may be deposited. Also resistance materials may be deposited, such as for example Ag/Pd/Glass and ruthenate, further dielectrics, such as polyimide, barium titanate and PMN/glass, and ferrites, such as MnZn ferrite. Au, Pt, Cu and Ag may be contained in the aerosol in the form of one of their chemical compounds and will be decomposed to the elemental metal by the application of further heat. The aerosol gas stream is directed to the regions at the substrate surface in which a structure is to be formed. At the same time a laser beam is directed and preferably focussed to the same surface area to fix the aerosol particles hitting the substrate surface in a confined area thereof. Due to the heating aerosol solvent concurrently evaporates. The laser may preferably be a Nd:YAG laser. The aerosol feed is preferably located nearby the laser beam. For example a plurality of tip orifices through which the aerosol exits are located at a small distance to the substrate surface. Suitable distance of the aerosol nozzle to the substrate will have to be adjusted to achieve optimum resolution (line widths and space). As material is only deposited in those areas in which the laser beam hits the surface, very fine lines and areas may be generated with this method. In order to achieve suitable thickness of the layer, multi-pass application is selected. Suitable interruption of the material application may be effected in this method by a mechanical shutter means, which interrupts aerosol feed to the surface. After aerosol deposition the structure elements produced are preferably annealed, for example in an oven, to decompose any compounds of the material to be deposited to the desired form, for example a metal.

Further a mill-and-fill technique may be used. In this case the three-dimensional structure in the dielectric layer is formed. A suitable fluid is filled into the recessed structure. Then material protruding over the structure recesses is removed with the aid of a doctor blade. The fluid shall have suitable properties to easily wet the surfaces exposed in the structure and to easily flow therein, but also not to flow on the surface of the substrate such that simple removal of the fluid from the surface thereof will be possible.

A gas dynamic spraying technique optionally followed by laser ablation will also be considered a direct write technique. A suitable gas dynamic spraying technique may for example be a high velocity particle consolidation (or cold gas dynamic spraying) method. In this case high-velocity, low temperature gas is used to carry a powder to the substrate. The particles are sprayed onto the substrate surface being carried in a high-velocity inert gas stream. With this technique structure elements may be produced which have a line width of about 20 - 40 µm. By using laser ablation structure size may even be decreased, for example to the submicron range.

Metallization in method step d) is preferably carried out by at least one of electroless and electrolytic metal plating techniques. Metal plating may be carried out on the whole outer side of the assembly or only on part thereof, namely in those areas which have been catalyzed and/or coated with the conductive particles layer.

The surface regions of the dielectric material exposed in the structure elements may be pre-treated by desmearing the regions chemically or with plasma technology prior to metallizing the surface regions. Depending on the dielectric type desmearing may be carried out with acid or alkaline permanganate, sodium hydroxide solution or organic solvents attack. Such application is well-known to those skilled in the art. Thereafter additional cleansing operations may be carried out.

Electroless plating techniques are well-known to those skilled in the art. It relates to those techniques in which a metal is deposited from a solution, preferably aqueous solution, to a dielectric material by using a catalyzing step in which catalyzing material is deposited to the surface areas to be plated and a plating step in which an electroless plating bath is used which comprises a solution of metal ions of the metals to be plated and a reducing agent that is able to reduce the metal ions at those surface areas being catalyzed to metal. The catalyzing agent generally contain noble metals either as a colloid, such as a palladium/tin(II)chloride or a palladium/organic protective agent colloid (NEOPACT®, Atotech), or a palladium complex dissolved in the catalyzing agent. In both cases the catalyzing agent adsorbes at the surface area to be catalyzed. Adsorption may be enhanced by so-called conditioners (e.g. polyelectrolytic compounds in an aqueous solution) which are applied prior to catalyzing the material.
In the case of colloids the protective agent should be removed prior to plating, this process step being termed "acceleration". In the case of complexing agents the adsorbed noble metal complex must be reduced to be active. Such reduction may be accomplished in a separate step prior to plating. The electroless baths may further contain additional components such as for example complexing agents for the metal ions, stabilizers and pH setting agents. The electroless plating bath may for example contain a copper complex, such as a copper EDTA or copper tartrate complex, formaldehyde, sodium hypophosphite or sodium dimethylamineborane as the reducing agent and sodium hydroxide as the pH setting agent. Apart from copper which is the most preferred metal to be plated other metals may also be plated in an electroless manner, such as Ni, Co, Ag, Au, Pd and the alloys thereof.

Instead of or in addition to electroless plating, metal may further be electroplated, *i.e.* be deposited electrolytically. This affords an electrically conductive layer, such as a metal layer plated from an electroless plating bath or a conductive particles layer. Alternatively a conductive polymer layer, such as for example a polypyrrole or polythiophene layer, may be formed. These layers are generated by the reaction of the respective monomer with an oxidizing agent (SELEO@, Atotech). Alternatively carbon may be deposited as a first electrically conductive layer prior to electroplating from a suitable suspension thereof. NEOPACT® is preferably suited to electroplate PTFE and polyimide dielectric materials. These priming substances may be applied to the entire surface area of the dielectric layer or only to those areas which shall be electroplated.

In one embodiment of the present invention the priming substance can be removed from the surface of the dielectric layer by laser ablation for example, if it has been applied to the entire surface thereof, so that this substance only remains in the structure elements. The metal layer is then formed only in the desired areas.

Another variation of priming the dielectric layer prior to metallization comprises depositing compounds to the layer which are rendered electrically conductive by irradiation with UV light. For example poly(bis(ethylthioacetylene)) is suitable for such application.

Electroplating is also well-known to those skilled in the art and comprises providing a substrate in at least part of the surface superficially conductive and an anode and bringing the substrate and the anode into contact with an electroplating solution which contains the metal ions of the metal to be plated. In this way a plurality of metals may be electroplated, such as for example Cu, Ni, Co, Ag, Au, Pd, Zn, Sn, Pb, Bi and the alloys of these metals with each other and with other elements. Copper is the most preferred. The metal may be electroplated using DC current or pulse current (unipolar, reverse pulse).

The plating conditions shall be designed such that metal is electroplated with a minimum levelling behaviour. Conventional copper plating baths suitable for this application preferably contain sulfuric acid having a copper concentration which is set at the maximum limit (20 - 40 g/I Cu²⁺). Sulfuric acid concentration is set up to 220 g/l. Further organic disulfide compounds, such as for example bis(3-sulfopropyl)disulfide disodium salt, are used. In addition levellers, e.g. polyalkylenealkoxylates and the alkyl-/cycloalkyl derivatives thereof, may be used.

Electroless plating and electroplating as well as all other operations for pre-treating the assemblies prior to metallization may be carried out in dip plants, in which the assemblies are held in vertical orientation, or in conveyorized plants, in which the assemblies are transported in a vertical, a horizontal or any other orientation. Transport direction in these latter plants is substantially horizontal.

The conductive particles are preferably applied to or metal is preferably deposited, especially plated, in the structure elements to such an extent that the structure elements are completely filled with the particles or the metal. Thus geometry of the conductor lines, lands and filled via holes is defined by the geometry of the trenches and via holes. If formation of the trenches and via holes is well-defined, width and thickness of the conductor lines, lands and the edges thereof as well as of the filled via holes will either be well-defined. Complete filling of the structure elements using one or more of the direct write techniques and thus entire formation of the conductor lines and conducting via holes by any of these techniques represents a viable way only if the deposited material has sufficient electrical conductivity and no change in volume or no change of other physical property on subsequent processing takes place. Due to complete filling of the three-dimensional conductor structure elements good adhesion thereof to the dielectric layer and thus good mechanical stability of the circuitry against thermal and mechanical stress is achieved. It has turned out that copper excellently adheres to the walls and the bottom of the structure elements. This may be due to the fact that the metal is not subject to high shear stress under these conditions. Moreover due to this configuration the assembly has good thermal dissipation properties. In addition failure due to dog-bone pads or fan-outs as well as residual rings at via holes are not observed. This also may obviate the necessity to etch away metal to generate the conductor pattern. This results in even better line definition. However, this advantage is only realized if metal is not deposited all over the outside surface of the assembly.

Metal is preferably plated on the whole surface area of the assembly. If too much metal is deposited to the three-dimensional structure then the structure elements are not only completely filled but metal will additionally be deposited to the outer side areas of the dielectric layer. In this case excess metal has to be removed from the surface regions on the assembly adjacent the structure elements by etching off excess metal to planarize the surface, while leaving the dielectric material free of conductive material and exposing the individual conductor structure elements. Apart from any finishing methods the electronic circuit is completed with this method step. Chemical solutions, such as for example a FeCl₃/HCl, a CuCl₂/HCl etching solution or an ammoniacal etching solution, may be employed for copper etching. Etching may also be performed electrochemically using DC or pulse current. Of course a combination of electrochemical and chemical etching may also be employed, for example removal of most of the metal by means of electrochemical etching and finally removal of the residue by chemical etching. Prior to etching the metal may be slightly brushed to level the surface thereof. Etching is preferably carried out at a temperature in the range of 25 - 45°C. Etching is preferably carried out in a conveyorized machine. Removal of excess metal can also be accomplished with a chemical-mechanical polishing method. Such process includes both mechanical polishing by motion of the assembly to be polished relative to a polishing means, such as a polishing wheel, and chemical polishing by means of an etching solution, such as for example peroxomonosulfate and/or peroxodisulfate or a phosphoric acid solution (*c*.*f*. S.Kondo et al. in: J.Electrochem.Soc., 147, 2907 (2000)). Combinations of the above methods may be employed. Using these methods metal is completely removed from the outer side areas such that metal only remains in the structure elements and is preferably flush with the upper surface of the dielectric material. This also includes filling via holes completely.

Following metallizing with copper further functional metal layers may be formed, which may serve as contact strips for wrap connections or for the bonding of chips. Functional layers suitable for ball grid arrays and for fine grid arrays are specifically suitable.

In one further embodiment of the present invention electronic components may be generated or placed in a circuit plane prior to finishing same by applying a conductive particles layer or any other conductive direct write layer and/or a metal layer. Such electronic components may be either fabricated on the dielectric *in-situ* or be picked and placed to the appropriate sites at the dielectric layer. The electronic components are preferably mounted to or fabricated in the component recesses. Component fabrication or mounting is preferably carried out prior to method step c).

For mounting electronic components in the component recesses first a dielectric material or an adhesive may be applied to the surface areas of the component recesses. Such dielectric material or adhesive is well-known to those skilled in the art. The dielectric material or adhesive is preferably a thixotrope liquid or paste to appropriate sites in the three-dimensional structure. The dielectric material or adhesive may preferably be applied to the component recesses using the micro-syringe or micro-pen technique. One preferred embodiment of the present invention comprises fabricating the electronic components in the component recesses by one or more techniques which are direct write techniques and which are identical with the conductive particles application techniques with the exception that appropriate material is deposited which is required to fabricate the components. Electronic components that may be fabricated *in-situ* are passive components, *i.e.* resistors, capacitors, inductors, antennas, RC filters, transformers, transducers, piezomagnetic and piezoelectric devices, or active components, such as transistors made from a combination of intrinsic conductive polymers and dielectric material. These components may be fabricated by using one or more of the direct write techniques to deposit resistor, capacitor (metal/dielectric/metal/dielectric and so on), inductor, conductor material and the like. The material deposited with the direct write technique may again be conducting, but also dielectric as well as magnetic material.

Conductor lines may be generated in the component recesses to make electrical connections to the terminals of the electronic components. This is especially required if integrated circuits are used as the electronic components. It will be possible to directly attach an integrated circuit in a recessed aperture in the substrate using dielectric material or adhesive in the aperture and picking and placing same therein. The conductor lines formed to create electrical connections to the terminals of the electronic components may be generated by one or more of the conductive particles application techniques or any other direct write technique which is able to deposit a conductor line (e.g., a direct write technique capable of producing a respective pattern of an electrically conductive organic polymer). Thereafter the conductor line may be plated with copper.

After the electronic components have been fabricated in or mounted to the component recesses and, where applicable, conductor lines have been formed the component recesses may be encapsulated. For this purpose further dielectric material is used to fill the component recesses to embed the components in the dielectric layer or the dielectric filling material being substantially flush with the dielectric layer surface. The dielectric material employed for encapsulation may be liquid dielectric material or moulding compound. After the component recesses have been filled with the dielectric material same is cured.

After the electronic components have been fabricated in or mounted to the component recesses and the recesses been filled to be substantially flush with the dielectric layer the conductor lines are manufactured in the trenches and via holes by any of the techniques described herein above.

After the above method steps have been carried out to generate one circuit plane further circuit planes may be generated. For this purpose at least one further dielectric layer is deposited on the surface of the assembly. The dielectric material of this further plane may be identical to the first one or be different. This can be done by traditional techniques of bonding prepregs to the assembly, coating the assembly with liquid dielectric or can also be achieved by applying one or more direct write techniques which are identical to the conductive particles application techniques with the exception that appropriate dielectric material is to be deposited to manufacture another dielectric layer.

The steps described herein above may be repeated to form conductor lines, conducting via holes and embedded electronic components, if applicable. For manufacturing further circuit planes additional dielectric layers may be sequentially applied to the assembly and conductor lines, conducting via holes and embedded components may be formed in these additional dielectric layers.

Depending on the original substrate chosen the following would be the next steps:
1) For single sided applications (least preferred) the assembly is separated from the carrier foil or rigid substrate. Then the outside face of the assembly may be processed using the method steps described herein above, thus completing the assembly. Thereafter this device can be sent to the final finishing section for the application of a solder mask and of a solderable coating. Then electronic components may be attached to the final external layer of the assembly. Finally the assembly may be tested and inspected.
2) For the double sided application described, in the case of a multilayer core as the carrier the assembly may then be final finished (application of the solder mask and of a solderable coating, attachment of electronic components to the final external layer and test and inspection), and in the case where a release sheet has been used, a repeat of the manufacture of the conductor structure as described is used on the side that has until then been attached to the release sheet. The assembly may then get to the final finishing operation as herein above.

Finally a terminating plane is produced on the outer sides of the assembly for securing the copper surfaces of the conductor structure against corrosion or during soldering. For this purpose the direct write techniques can be used to deposit solder, solderable finishes, for example a permanent or secondary resist, preferably a flux lacquer, and a solder mask onto the external board surface to complete the operation prior to assembly.

The following examples serve to describe the invention in more detail:
- **Fig. 1:**: represents the method according to the present invention schematically in a first diagram;
- **Fig. 2**: represents a first variation of the method as shown in **Fig. 1;**
- **Fig. 3**: represents a second variation of the method as shown in **Fig. 1;**
- **Fig. 4**: represents a third variation of the method as shown in **Fig. 1;**
- **Fig. 5**: represents another embodiment of the method of the present invention including forming embedded electronic components;
- **Fig. 6a:**: represents a component part type 0 having two dielectric layers and two circuit planes;
- **Fig. 6b:**: represents a component part type 1 having three dielectric layers and two circuit planes;
- **Fig. 6c:**: represents a component part type 2 having two dielectric layers and three circuit planes;
- **Fig. 6d:**: represents a component part type 3 having three dielectric layers and three circuit planes;
- **Fig. 6e:**: represents a component part type 4 having a multilayer core carrier either in a unidirectional or bidirectional build up having one or two dielectric layers and two circuit planes each.

Like reference numerals are used in the individual figures for the same elements.

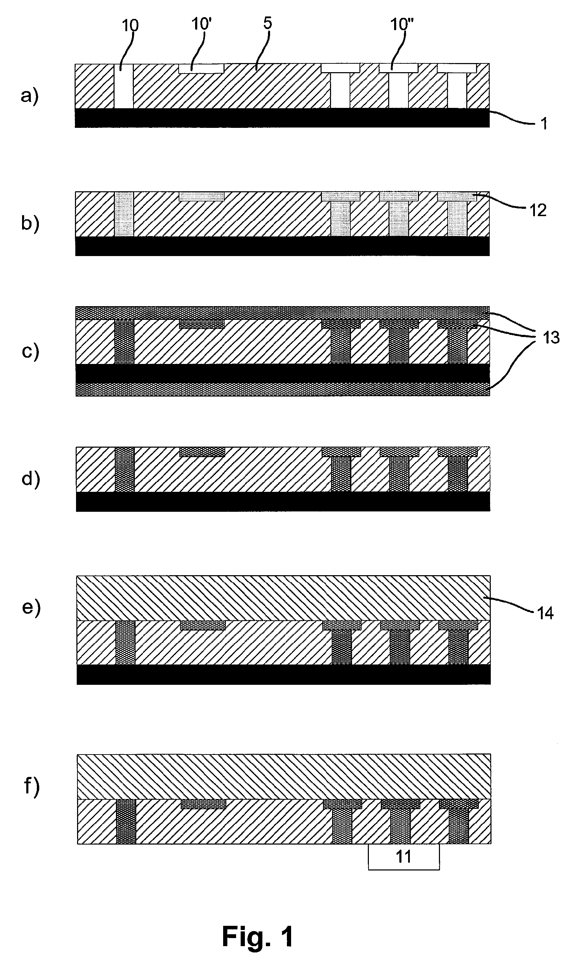

**Fig. 1** represents a schematic view of the configuration of a circuit plane during the construction of a multilayer, the method steps a) through e) representing individual process steps in the process. The assembly consists of a dielectric layer **5** and of a carrier **1,** which is made from a metal layer until the metal layer has been removed. In **Fig.1a** it is shown that the dielectric layer **5** has been provided with structure elements comprising conductor lines **10'** and blind via holes **10** as well as conductor lines combined with via holes **10",** by means of laser ablation. The conductor lines combined with the via holes **10"** extend down to the metal layer **1.** In **Fig. 1 b** it is shown that the conductor lines **10',** the blind via holes 10 and the conductor lines combined with via holes **10"** have been coated with a coating of priming substances **12.** This coating **12** is shown in **Fig. 1 c** to have been plated and entirely filled with metal **13.** Excess metal 13 is plated on the surface of the dielectric layer **5.** The metal layer **1** has been used for this purpose as a contacting element to provide the coating of priming substances **12** with electric current. For this purpose first a copper layer has been formed with electroless plating to form a first electrically conducting layer. Then metal could also be electroplated. Therefore also the conductor lines **10'** could be electrically contacted via the blind via holes **10** and the metal layer **1.** After excess metal has been removed by etching (**Fig. 1d**) a further dielectric layer **14** has been applied (view of **Fig. 1e**) so that a multilayer is formed. The metal layer **1** is removed in the last method step (**Fig. 1f**). An electronic component **11** is schematically shown to be attached to conductor structure elements **10,10',10".**

In this embodiment of the present invention the metal layer **1** of the carrier serves to provisionally cover via holes **10** and the conductor lines combined with via holes **10"** from the lower side of the assembly. The metal layer **1** makes easy metallization possible by direct electrical connection. At the same time the metal layer **1** also serves as a land area or base of the laser bore holes since the laser cannot remove the metal layer **1.** In addition the metal layer **1** can form a circuit pattern option by means of conventional photostructuring technique. Then the metal layer **1** can also be removed by etching together with the metal deposited thereon, preferably at the finished multilayer, the contact areas of the filled blind via holes **10** being exposed thereby. In this embodiment the latter contact areas are qualified as ball grid array (BGA) pads. Dog-bone pads, fan outs and residual rings cannot form with this method in contrast to conventional methods.

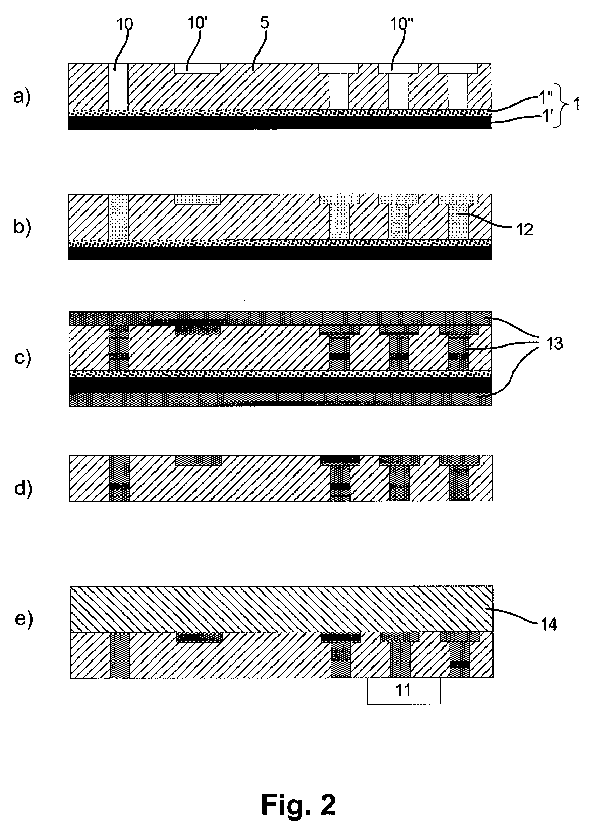

Corresponding to **Fig. 1 Fig. 2** represents schematically the configuration of a circuit plane during the construction of a multilayer, the carrier **1** being a base metal plate **1'** which is plated with bright nickel **1"** or a polished steel plate **1'** plated with a copper layer **1 ".** Contrary to **Fig. 1** the metal layer **1'** and the copper layer **1"** are already removed in the method step according to **Fig. 2d.** Due to this variation the method is shortened.

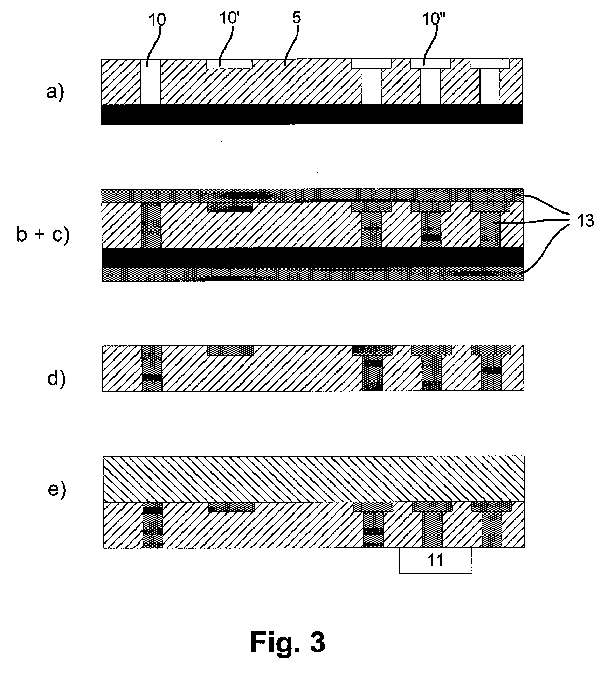

Corresponding to **Fig. 1 Fig. 3** represents schematically the configuration of a circuit plane during the construction of a multilayer, the method steps according to **Fig. 3b** and **Fig. 3c** being combined in one single method step. This increases efficiency of the process.

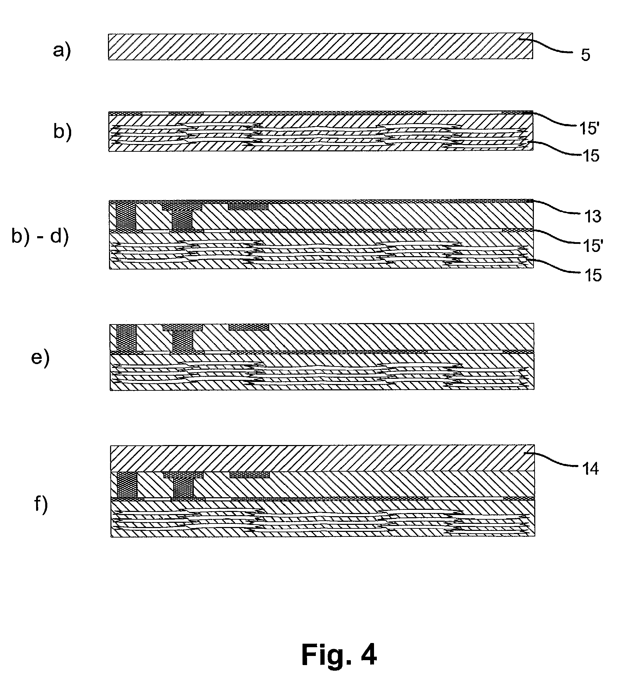

**Fig. 4** represents schematically the configuration of a circuit plane during the construction of a multilayer, this representation corresponding in principle to **Fig. 1.** A PCB **15** having a copper outer layer **15'** with conductor structure elements is used as a carrier. In a preceding step the dielectric layer **5** is applied to the copper outer layer **15'.** In accordance with **Fig. 1** generation of the conductor structure elements in the dielectric layer, further application of the base layer or catalyzation, respectively, and metallization corresponding to the method steps according to the **Figs. 4b** through **4d** follow. Thereafter excess metal **13** is removed in the method step according to **Fig. 4e.** In the method step according to **Fig. 4f** a further dielectric layer **14** is applied as described in **Fig. 1.**

In this embodiment of the invention part of the embedded blind via holes and conductor lines combined with blind via holes are formed such that they extend down to the copper outer layer **15'** and come into electrical contact with parts of this copper outer layer.

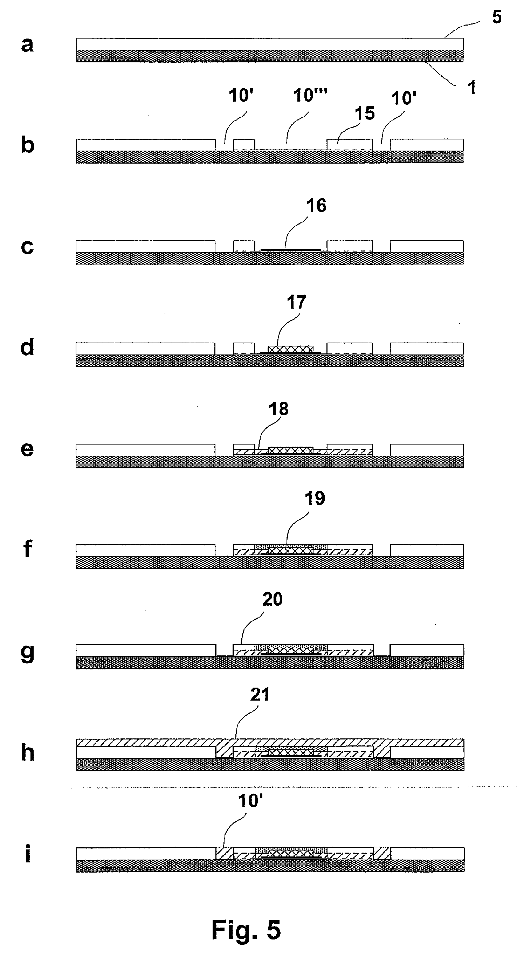

In a further example of the present invention a process diagram is shown in **Fig. 5** to additionally include the formation of component recesses, the generation of connecting lines for the electronic component therein and the mounting of the electronic components.

To begin with, a carrier **1** is provided with a dielectric layer **5 (Fig. 5a).** By laser ablation structure elements are formed in the dielectric layer **5** these apertures being for example conductor line recesses **10'** and component recesses **10"' (Fig. 5b).** By dashed lines further hidden recesses **15** are indicated in the figure to be designed for the generation of conductor structure elements electrically connecting the terminals of the electronic component to conductor lines to be formed in the structure elements 10'. Thereafter an adhesive is applied to the bottom of the component recess **10"'** to form an adhesive layer **16** in the recess which is slightly smaller than the recess bottom area and largely corresponds to the surface area of the component to be mounted therein **(Fig. 5c).** Then the component **17,** a resistor for example, is mounted to the component recess **10"',** being bonded to the bottom thereof by means of the adhesive layer **16** (**Fig. 5d**). Then a conductor structure pattern **18** is formed in the component recess **10'''** and in the recesses **15,** which are hidden in **Fig. 5** (**Fig. 5e**). This pattern may preferably be formed by a conductive particles application technique or by any other direct write technique being capable of forming an electrically conductive pattern, because no further patterning steps such as photoresist application/exposure/development sequences are required, but a single patterning/depositing step is sufficient. Thereafter the component recess **10'''** and the recesses **15** designed for the connecting lines **18** are embedded by using a dielectric material **19 (Fig. 5f).**
Subsequently a coating of priming substances **20** is deposited all over the surface of the assembly (**Fig. 5g**). The priming substances may be electrically conducting particles deposited by any of the conductive particles application techniques or a pre-treatment conventionally used in plating technology such as for example a conditioning/catalyzing/acceleration sequence. Then the assembly is plated all over the surface thereof with a metal, preferably with copper (**Fig. 5h**). This method may be carried out by plating copper in an electroless manner with any conventional means and then by electroplating copper. Finally excess copper is removed from the surface of the assembly by etching, leaving copper only in the conductor lines **10'** and via holes, whereas the other surface areas are free from copper **(Fig. 5i).** Using this method step the conductor lines and via holes are **10'** are finally generated.

Hereinafter a variety of configurations of the assembly manufactured according to the present invention are shown:

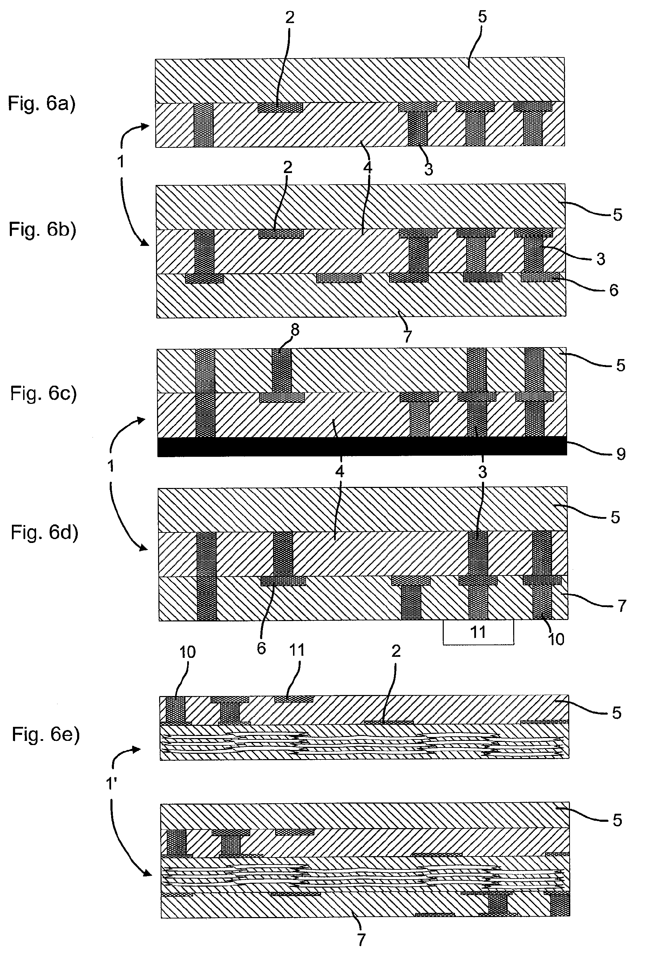

For the manufacture of the component part type 0 corresponding to **Fig. 6a** a carrier **1** having a circuit pattern (conductor lines **2** and blind holes **3)** embedded into a dielectric layer **4** is used as the starting material. The carrier **1** may be a copper foil or a steel plate which is plated with nickel or with copper (not shown) coated with the dielectric layer **4** or any other carrier. After the upper circuit plane has been finished a prepreg **5** is applied to the dielectric layer **4.** In another variation functional layers may be provided to the surface of the copper lines **2** and filled blind holes **3** to serve as bonding or soldering sites. The second dielectric layer **5** can be provided with a structure in accordance with the present invention and/or a further layer may be laminated. In still another variation functional layers may be deposited to the copper surfaces of the conductor lines **2** and blind holes **3** (surface finishing) which are suitable for surface mounting chip size packages (variations not shown).

For the manufacture of the component part type 1 corresponding to **Fig. 6b** a component part type 0 is employed and the copper layer located at the lower side of the carrier **1** which serves as a metal base layer, is provided with structure elements for the production of conductor lines **6.** Thereafter further circuit planes may be manufactured at this side by laminating prepregs **7** on this surface and by providing the prepregs with a circuit pattern in accordance with the present invention (not shown).

For the manufacture of the component part type 2 corresponding to **Fig. 6c** a component part type 0 is employed and the upper dielectric layer **5** is provided with conductor structure elements by generating further blind vias holes **8** and conductor lines (not shown). Thereafter a dielectric final layer serving to accommodate electronic components is applied to the uppermost circuit plane. This dielectric layer may be provided with conductor structure elements in the same way (not shown). Finally the copper layer located at the lower side of the carrier which serves as a metal base layer **9,** is provided with structure elements for the production of conductor lines (not shown). In another variation this copper base layer may also be removed by etching (not shown). In still another variation functional layers may be deposited to the copper surfaces (surface finishing) which are suitable for surface mounting chip size packages (not shown).

For the manufacture of the component part type 3 corresponding to **Fig. 6d** a component part type 1 according to **Fig. 6b** is employed. One or both dielectric layers **5, 7** which are attached to the carrier **1** are provided with conductor structure elements **10** carrying out the method according to the present invention (conductor structure elements on the lower dielectric layer shown). An electronic component **11** attached to a conductor structure is shown schematically. Accordingly conductor lines (not shown) and blind holes **10** are formed. Thereafter further layers may be generated or a copper layer present at the lower side of the carrier may be removed by etching (not shown).

For the manufacture of the component parts type 4 corresponding to **Fig. 6e** a multilayer core carrier **1'** is employed. This carrier **1'** may optionally be provided with circuit patterns **2.** In this case dielectric layers **5,7** are applied either to both sides (lower part of the figure) or only to one side of the multilayer core carrier **1'** and the dielectric layers **5,7** are provided with conductor structure elements **10,11** in accordance with the invention. In the lower embodiment shown in **Fig. 1e** a second dielectric layer **7** is applied to the upper side of the multilayer core carrier **1',** after the first dielectric layer **5** has been provided with conductor structure elements **10,11,** after the conductor lines **11** have formed and filled blind via holes **10** have been generated.

In the following examples for the manufacture of electronic circuit assemblies according to the present invention are described in detail:

### Example 1:

1. To manufacture an electronic circuit assembly an already constructed multilayer core having for example ten layers was selected in a first method step. This assembly was to be treated according to the further method steps as follows (such multilayer core material could also have another number of layers, such as for example only two layers or, alternatively, a larger number of layers such as for example 50 layers, depending on the application required (IC packaging for example requiring two to ten layers)):
2. In a second method step a dielectric material was selected having properties suitable for the application required. The dielectric material could for example be a polyimide foil having a thickness of 50 µm, this material being suitable for IC packaging purpose (alternatively, dielectric material having a thickness of for example 10 - 100 µm could be used). This material was applied to one or both sides of the multilayer core (on both sides being preferred for dimensional stability reasons, even if circuit structure is to be formed on one side thereof only).
3. For forming a three-dimensional structure in the dielectric layer on one side only or on both sides, if required, state of the art laser ablation tools were used. Such a tool was the UV laser machining apparatus having the trade name Microbeam® of Siemens, which was preferred. This apparatus has the highest write speed currently available with a commercial instrument. In a method variation a LPKF Excimer laser with a laser wavelength of 308 nm was used to provide scans over the assembly and to provide a structure to the dielectric layer using the projection method. A mask with 15 µm lines and 20 µm spaces was used. The pulses of the laser had the energy of 650 mJ each.
   The three-dimensional structure formed consisted of via holes positioned to be coincident with the circuit pattern on the multilayer core, further of trenches that later would form the conductors connecting electronic circuits together and of recesses of suitable size into which suitable passive components could be placed later in the production sequence.
4. Thereafter a thixotrope dielectric or adhesive material was applied to appropriate recess sites in the three-dimensional structure produced in the last method step using micro-pen, micro-syringe or pick-and-place technology (all commercially available devices) at one (first) side of the assembly produced so far.
5. Industrial standard discrete components of suitable function, electrical properties and size (resistors, capacitors, etc.) were then inserted into the recesses containing the thixotrope dielectric material on the first side of the core by utilizing standard pick-and-place equipment.
6. Then the recessed components on the first side of the core were encapsulated with liquid dielectric material or with a suitable moulding compound ensuring that the encapsulant and the component top surface were flush with the surface of the dielectric layer after curing. This further dielectric material could again be polyimide, in this case being liquid and, once cured, solid.
7. Thereafter the assembly so far produced was cured using industrial standard equipment. Thus the dielectric material used to encapsulate the component recesses rendered solid. The temperature applied depended on the materials used.
8. If the second side of the multilayer core had also been coated with the dielectric material and the dielectric material layer on this side provided with a three-dimensional structure comprising via holes, trenches and recesses, method steps 4 - 7 were repeated to apply thixotrope dielectric material into the recesses in this layer. Then discrete components were inserted into these recesses and encapsulated in these recesses. Finally the assembly so far produced was cured.
9. The assembly having encapsulated components was then desmeared using industry standard chemicals, *e.g.,* Securiganth® P (Atotech; permanganate etch solution), or using plasma etching technology, utilizing *e.g*., fluorine and/or oxygen gas mixtures.
10. Then the complete structure was metallized using suitably modified industry standard dielectric metallization process chemicals to ensure excellent adhesion and copper deposit quality (*e.g*., electroless or direct (without electroless) metallization technology). Such copper plating baths are well-known to those skilled in the art to achieve suitable properties for enhanced metal adherence to the dielectric.
11. Thereafter using the complete surface conductivity, the entire structure was electroplated utilizing suitably modified industry standard copper electroplating processes, ensuring that the three-dimensional features were completely filled with conductive material.
12. Then the unwanted copper was removed utilizing a combination of modified industry standard etching and planarizing processes, thereby leaving the conductive material in the via holes and trenches and the connections to the embedded components flush with the surface of the initially deposited dielectric layer, whereas the dielectric layer was entirely exposed and copper completely removed therefrom. The excess metal was removed completely in two method steps, the conductor lines being conserved:
   In the first step a horizontal conveyorized line was used:
      Etch plant Pill
      FeCl₃/HCl, 35°C
      1.2 m/min conveyor speed., 4.6 µm removal depth
   In the second step a vertical plant was used:
      Vertical module
      Potassiumperoxomonosulfate, 28°C
      1.7 µm removal depth
   The dielectric layer could at this stage require a further step to remove any conductive material remaining on the surface after the planarizing process dependent on the metallization system utilized. For this purpose another etching step was inserted.
13. All preceding method steps except method step 1 were then multiply repeated to generate a couple of further layers on one or both sides of the assembly so far manufactured. These layers were also produced having conductor structure elements in via holes connecting adjacent layers, trenches and component recesses with encapsulated components. The number of repetitions of method steps as well as the individual three-dimensional layout and suitable passive components in each layer were dependent on the circuit design in question.
14. At the end of the required number of cycles the finished electronic circuit assembly was then proceeded to the final finishing operations well-known to those skilled in the art, such as to the application of a solder mask using a direct write technique (*e.g*., industrial ink-jet), of a solderable coating (*e.g*., OSP, ENIG, immersion tin), to the profiling and final inspection (*e.g*., electrical testing), packing and shipping.

After finishing an electronic circuit assembly with a couple of layers on one or both sides of the multilayer core was produced, the layer comprising via holes between adjacent conductor layers, conductor lines and encapsulated passive components. The individual structure elements (via holes and conductor lines in the layers) were extremely small: Line widths and spaces ranged from 15 - 30 µm and via hole diameter from 25 - 50 µm.

### Example 1a:

Example 1 was repeated. In method step 3 instead of generating the three-dimensional structure by laser ablation, it was created in each cycle by an alternative method variant, the variants available comprising hot embossing, micro-imprint technology, micro-stamping and moulding. These alternative techniques also lead to extremely fine conductor lines and via holes in the same range as outlined in Example 1.

### Example 2:

Example 1 was repeated except for the following differences:
1. In method step 1 instead of a multilayer core a suitably prepared (e.g., polished) stainless steel press plate was used. It was plated over its entire surface using industry standard copper electroplating processes to form a non porous layer of copper having a thickness of below 2 µm. Thickness distribution of this copper layer was below 5 % (standard deviation) across the entire surface of the stainless steel plate.
2. In method step 2 instead of using a polyimide dielectric material Thermount® (DuPont) laminate was used, which is an Aramid@ (DuPont) reinforced laminate, preferably containing epoxy resin. This material is especially suitable for mobile phone or other handheld applications.
3. In method step 3 instead of forming the three-dimensional structure comprising via holes positioned to be coincident with the circuit pattern on the core the via holes were positioned to be coincident with the circuit pattern required on the outer layer of the finished circuit board
4. - 12., 12a., 13. Then the circuit layout of the circuit planes on both sides of the press plate was produced according to method steps 4. - 12. of Example 1. For metallization in method step 10 the following process sequence was used: DS-PTH process sequence vertical:

| | |
|---|---|
| Sweller Securiganth® (Atotech) | 2 min @ 77°C |
| Permanganate etch solution (Atotech) | 8 min @ 70°C (ultrasonic agitation) |
| Reducer conditioner (Atotech) | 5 min @ 48°C |
| Cleaner Securiganth® | 5 min @ 57°C |
| Etch cleaner Securiganth® | 2 min @ 25°C |
| Pre-dip Neoganth® (Atotech) | 1 min @ 25°C |
| Activator Neoganth® | 5 min @ 39°C |
| Reducer Neoganth® | 5 min @ 30°C |
| Electroless Copper Printoganth® (Atotech) | 30 min @ 32°C |

### b) Coating the metal layer in the Examples 1 and 2

Metallizing conditions in vertical operation mode:

| | |
|---|---|
| Cleaner Cupra Pro (Atotech) | 5 min @ 39°C |
| Etch cleaner Securiganth® | 30 sec @ 28°C |
| Pickling (10 % w/w H₂SO₄) | 2 min @ 25°C |
| Electroplating with Cupracid® (Atotech) at current density of | 1 A/dm², 25°C |

Thereafter the circuit assembly was released from both sides of the stainless steel press plate by etching the copper layer from around the periphery of the plate and sliding the assembly away from the plate in a water rinse. No further circuit planes were produced as in Example 1.

12b. Thereafter the outer layers of the two separated PCB sub-assemblies created in the last step were planarized as described in Example 1 with respect to method step

12. Alternatively the remaining copper layer was imaged to give a circuit pattern on the outer layer of the assembly.

14. Final finishing was performed as described in example 1.

15. The stainless steel press plate was recycled via industry standard CMP (Chemically Mechanical Polishing) technology.

### Example 3:

Example 2 was repeated, but in this case a non-stick or release film on a recyclable or deposable rigid carrier layer rather than a copper layer on a stainless steel press plate was used at the beginning of the process.

### Example 4:

Example 1 was repeated. But in this case a direct write process was utilized to create the embedded passive components in the recesses *in-situ* created as part of the three-dimensional structuring. Therefore method steps 4 and 5 of Example 1 were replaced with this method step.

In one variation of the Example the micro-pen technique was used to write the resistive material for a resistor or conductive material for a capacitor into the recesses created for this purpose. Layers of dielectric were be added using the industrial ink-jet technique. Alternatively also the micro-pen technique was utilized.

In another variation of the Example the M³D laser enhanced aerosol deposition technique of Optomec for producing the metal layer of a capacitor, followed by dielectric deposition via the micro-pen technique or industrial ink-jet technique were utilized. This again was followed by further alternate layers of metal / dielectric.

In still another variation of the Example the bare die (integrated circuit) was placed into a recess and connected to the circuit of the assembly by directly using a direct write deposition method (industrial ink-jet, micro-pen or micro-syringe, laser aerosol, mill-and-fill technique). Then this die was encapsulated as described in Examples 1 above.

### Example 7:

Example 1 was repeated.

In this case, however, the process included the use of an adhesion promoter based on silanes in one variation or on urethanes in another variation, to increase the adhesion of the conductive material deposited into the three-dimensional structure. The material was deposited via a direct write technique. The conductor structure was built up using a combination of high-build electroless copper (2 - 5 µm thickness) to line the three-dimensional structure and to give the best electric conductivity and by coating with a copper ink deposited via the industrial ink-jet technique in one variation or the M³D laser enhanced aerosol deposition technique. This copper ink had a lower electric conductivity based on current technology.

This procedure replaced steps 9. -12. of Example 1.

## Claims

1. Method of manufacturing an electronic circuit assembly, comprising one or more dielectric layers, each layer having a conductor line structure, the method comprising the following method steps:
a) providing the dielectric layer;
b) forming a three-dimensional structure in the dielectric layer so as to provide one or more structure elements in the layer selected from the group comprising via holes, trenches and component recesses;
c) applying a fluid to at least part of surface regions of the dielectric layer exposed in the structure elements, the fluid containing or forming at least one of conductive particles or intrinsic conducting polymer on the surface; and
d) metallizing at least part of the surface regions.

2. Method according to claim 1, **characterized in that** the application of the conductive particles suspended in the fluid or formed from a fluid in step c) is carried out by one or more direct write techniques selected from the group comprising ink-jet technique, micro-pen or micro-syringe technique, transfer printing, mill-and-fill and laser aerosol technique.

3. Method according to claim 2, **characterized in that** the direct write technique is a conductive particles application technique.

4. Method according to any one of the preceding claims, **characterized in that** the dielectric material is bonded to a carrier.

5. Method according to any one of the preceding claims, **characterized in that** the carrier is selected from the group comprising a multilayer core material, a metal plate, a dielectric film and a semiconductor device.

6. Method according to any one of the preceding claims, **characterized in that** the carrier is removed from the dielectric layer after method step c) or d).

7. Method according to any one of the preceding claims, **characterized in that** metallization in method step d) is carried out by at least one of electroless and electrolytic metal plating techniques.

8. Method according to any one of the preceding claims, **characterized in that** metallization in method step d) is carried out by copper plating.

9. Method according to any one of the preceding claims, **characterized in that** conductive particles are applied to or metal is deposited in the structure elements to such an extent that the structure elements are completely filled with the particles or the metal.

10. Method according to claim 9, **characterized in that** excess metal is removed from surface regions on the assembly adjacent the structure elements by etching.

11. Method according to any one of the preceding claims, **characterized in that** the three-dimensional structure is generated by laser ablation.

12. Method according to any one of the preceding claims, **characterized in that** electronic components are mounted to or fabricated in the component recesses prior to method step b).

13. Method according to claim 12, **characterized in that** a dielectric material or an adhesive is applied to the component recesses prior to mounting the electronic components.

14. Method according to claim 13, **characterized in that** the dielectric material or adhesive is a thixotrope liquid or paste.

15. Method according to claim 13 or 14, **characterized in that** the dielectric material or adhesive is applied to the component recesses using the micro-syringe technique.

16. Method according to claim 12, **characterized in that** the electronic components are fabricated in the component recesses by one or more of the direct write techniques.

17. Method according to any one of claims 12 - 16, **characterized in that** connector lines are generated in the component recesses so as to create electrical connections to terminals of the electronic components.

18. Method according to claim 17, **characterized in that** the connector lines are generated by one or more of the conductive particles application techniques.

19. Method according to claim 18, **characterized in that** the connector lines formed by one or more of the conductive particles application techniques are plated with copper.

20. Method according to any one of claims 12 - 19, **characterized in that** the component recesses are encapsulated after the electronic components have been mounted or generated and after electrical connections to the terminals of the electronic components have been made.

21. Method according to claim 20, **characterized in that** encapsulation is carried out with liquid dielectric material or with moulding compound.

22. Method according to any one of claim 21, **characterized in that** the liquid dielectric material or the moulding compound is cured.

23. Method according to any one of the preceding claims, **characterized in that** the surface regions of the dielectric material exposed in the structure elements are pre-treated by desmearing the regions chemically or with plasma technology prior to metallizing the surface regions.

24. Method according to any one of the preceding claims, **characterized in that** at least one further dielectric layer is deposited on the surface of the assembly.

25. Method according to claim 24, **characterized in that** the further dielectric layer is formed from a prepreg or a liquid.

26. Method according to claim 25, **characterized in that** the further dielectric layer is formed from a liquid and is applied to the assembly by one or more of the conductive particles application techniques.

27. Method according to any one of claims 24 - 26, **characterized in that** the further dielectric layer is provided with a three-dimensional structure and the three-dimensional structure is filled with at least one of conductive particles and metal.

28. Method according to any one of the preceding claims, **characterized in that** the electronic circuit assembly is a PCB, a multi-chip module or a chip carrier.
